Europäisches Patentamt

European Patent Office

Office européen des brevets

(11) Publication number: **0 323 539**
**A1**

# EUROPEAN PATENT APPLICATION

(21) Application number: 88100193.7

(51) Int. Cl.4: **G01R 31/36**

(22) Date of filing: 08.01.88

(43) Date of publication of application:
**12.07.89 Bulletin 89/28**

(84) Designated Contracting States:
**BE CH DE FR GB LI NL SE**

(71) Applicant: **RAMOT UNIVERSITY AUTHORITY FOR APPLIED RESEARCH & INDUSTRIAL DEVELOPMENT LTD.**
**Tel Aviv University Ramat Aviv**
**Tel Aviv(IL)**

(72) Inventor: **Peled, Emanuel**
**Hanotea Street**
**Even Yehuda(IL)**
Inventor: **Reshef, Israel**
**38 Hameri Street**
**Givatayim(IL)**
Inventor: **Rozen, Shlomo**
**37 David Hamelech Street**
**Herzliya(IL)**
Inventor: **Yamin, Herzel**
**12 Habitachon Street**
**Kiron(IL)**
Inventor: **Kelrich, David**
**4 Kdoshey Struma**
**Ramat-Hasharon(IL)**

(74) Representative: **Modiano, Guido et al**
**MODIANO, JOSIF, PISANTY & STAUB**
**Modiano & Associati Baaderstrasse 3**
**D-8000 München 5(DE)**

(54) **Method for determining the state-of-charge of batteries, particularly lithium batteries.**

(57) Method for determining the state-of-charge of batteries having constant discharge curves, such as lithium batteries, involves the steps of: (a) measuring the temperature of the battery; (b) loading the battery to prdouce a high discharge for a short period of time; (c) after a short rest period, measuring the open-circuit-voltage of the battery; and (d) determining from the measured temperature and open-circuit-voltage the residual state-of-charge of the battery. Preferably, the residual state-of-charge of the battery is determined by comparing the measured temperature and open-circuit-voltage with reference tables showing the state-of-charge at different temperatures and open-circuit-voltages for the respective battery, but may be determined also by a mathematical computation.

FIG 1

# METHOD FOR DETERMINING THE STATE-OF-CHARGE OF BATTERIES, PARTICULARLY LITHIUM BATTERIES

The present invention relates to a method for determining the state-of-charge of batteries with an unknown history. The invention is particularly applicable with respect to lithium batteries, such as $Li/SO_2$ and $Li/SOCL_2$ batteries, and is therefore described below with respect to this application, although it will be appreciated that the invention may be advantageously used for other batteries as well, such as zinc-manganese-dioxide alkaline batteries.

It is frequently very important to determine the state-of-charge of a battery, i.e., the residual capacity (ampere-hours) still remaining in a battery having an unknown history. However, some batteries, particularly the lithium batteries such as $Li/SO_2$ and $Li/SOCL_2$ batteries, have very constant or flat discharge curves which give no information with respect to the battery state-of-charge. Insofar as we are aware, no practical, non-destructive technique has been devised for measuring the state-of-charge of lithium batteries or other batteries having constant discharge curves without knowing their history. In addition, in the case of $Li/SO_2$ batteries, the open-circuit-voltage (OCV) is independent of the state-of-charge in the range of 60-100% capacity. For example, a fully charged 10 Ah $Li/SO_2$ cell has the same OCV (2.993 ± 0.003V) as that of a 40% discharged cell. Thus, it is impossible to predict the state-of-charge from the OCV.

An object of the present invention is to provide a novel method for determining the state-of-charge batteries having an unknown history, which method and apparatus are particularly useful with respect to lithium batteries, or other batteries having constant discharge curves, such as zinc-manganese-dioxide alkaline batteries.

According to a broad aspect of the present invention, there is provided a method for determining the state-of-charge of a battery, particularly one having an unknown history, characterized in the steps: (a) loading the battery with a predetermined load to produce a high discharge for a short predetermined time, (b) after a short recovery time, measuring the recovery open-circuit-voltage ($OCV_R$) and the corresponding recovery time of the battery, and (c) determining the state-of-charge of the battery from the measured recovery open-circuit-voltage, for the predetermined load, loading time and recovery time for the particular type of battery. For best results, the temperature is also measured, but may be approximated when the test is performed at standard ambient temperatures.

Step (b) above may be performed by measuring the recovery open-circuit-voltage after a predetermined recovery time, or by measuring the recovery time to reach a predetermined recovery open-circuit-voltage. Preferably, the temperature is also measured, but the method may be produced within approximate temperature ranges. For step (c), there may be used calibration curves pre-prepared according to the type and size of the battery, temperature (T), load (L), load time ($t_L$), and recovery time ($t_R$). It is possible to select different sets of parameters, within a certain range, but each set of parameters (L, $t_L$, $t_R$) produces a different calibration curve for a predetermined temperature (T).

In the preferred embodiment of the invention described below, the battery is loaded such as it would produce a discharge of nominal capacity in 1-30 hours, about two hours having been found preferred for lithium batteries, and 5-20 hours having been found preferred for zinc-manganese-dioxide alkaline batteries. In addition, the battery is preferably loaded to produce the high discharge for a period of 0.1-300 seconds, a period of 10-60 seconds having been found preferred for lithium batteries.

It has been found that loading the batteries to produce the high discharge for the short period of time before measuring the open-circuit-voltage, is effective to remove all or substantially all of a passivating layer which forms on the lithium anode if a substantial period of time has transpired from the last use of the battery. Thus, it was found that when the recovery open-circuit-voltage ($OCV_R$) of the battery is measured without a sufficient pre-loading of the battery to produce the high discharge for the short period of time, this passivating layer on the anode reflects the polarization of the anode, and therefore the subsequently measured recovery open-circuit-voltage has little correlation to the state-of-charge of the battery.

The short recovery time ($t_R$) after the load has been removed was also found to be very important in order to provide reproducible predictions of state-of-charge. Thus, it was found that when the recovery period is too short, the measured recovery open-circuit-voltage is influenced by the resistive ohmic voltage drop in the solution, and the anodic polarization, which have little correlation with the state-of-charge of the battery. On the other hand, when the recovery period is too long, it was found that the sensitivity of the method decreases. Preferably this recovery period, before the recovery open-circuit-voltage is measured, should be from 0.1-1000 seconds, a recovery period of 10-60 seconds having been found particularly effective with respect to lithium batteries.

In the preferred embodiment of the invention described below, the state-of-charge of the battery is determined by comparing the measured temperature and recovery open-circuit-voltage with reference tables showing the state-of-charge for different temperatures, and recovery open-circuit-voltages for the respective battery and for the above-mentioned parameters L, $t_L$, $t_R$. However, it was also found that, with respect to 10 Ah Li/SO$_2$ batteries, a close approximation of the residual charge of the battery may be obtained by computing it from the measured temperature and recovery open-circuit-voltage according to the following equation:

$$1nQ = 28.05 [OCV_R + (T-25) \bullet 0.4 \bullet 10^{-3}] - 79.325$$

wherein:

Q is the residual charge in amp hours;

1nQ is the natural log of Q;

$OCV_R$ is the measured recovery open-circuit-voltage of a single cell, or in the case of a plural-cell battery, the voltage of the battery divided by the number of cells in series, at temperature T. T is the measured temperature (degrees C) in the range 0-50° C;

and wherein: the load is 0.5 ohm, the loading period is 60 seconds, and the recovery period is 30 seconds.

It will thus be seen that the invention provides a method and apparatus for measuring the state-of-charge of batteries having flat discharge curves, such as lithium batteries, which method is non-destructive, is fast, does not require knowledge of the service history of the battery, and does not waste the battery capacity. With respect to the latter advantage, the method consumes a very small fraction, less than 1% of the battery capacity.

Further features and advantages of the invention will be apparent from the description below.

The invention is herein described, by way of example only, with reference to the accompanying drawings, wherein:

Fig. 1 schematically illustrates a setup for measuring the state-of-charge of a battery in accordance with the invention;

Fig. 2 illustrates the two room temperature curves showing the relationship of the residual capacity of a single-cell (A) and a plural-cell Li/SO$_2$ battery (B) as a function of the recovery open-circuit-voltage ($OCV_R$) measurements in accordance with the present invention, the $OCV_R$ of the plural-cell battery being obtained by dividing the measurement by the number of cells in series of the battery.

Fig. 3 is a roon temperature curve illustrating a similar relationship as in Fig. 2 but with respect to Li/SOCL$_2$ batteries of D-size, when the load was 100 ohm, the load time ($t_L$) was 60 seconds, the recovery time ($t_R$) was 120 seconds, and the temperature (T) was 25° C;

Fig. 4 illustrates the relationship of $OCV_R$ at various room temperatures for different battery residual capacities, of 10 Ah Li/SO$_2$ battery, wherein C = 9.4 Ah, D = 7.1 Ah, E = 4.8 Ah, and F = 3.0 Ah.

Fig. 5 is a block diagram illustrating one form of apparatus constructed in accordance with the present invention;

Fig. 6 is a schematic diagram more particularly illustrating the measuring and display interface circuit in the system of Fig. 5;

Fig. 7 illustrates the front panel of a state-of-charge meter in the system of Fig. 5; and

Fig. 8 is a flow diagram illustrating the programmed sequence of operations to be performed by the microprocessor in the system of Fig. 5.

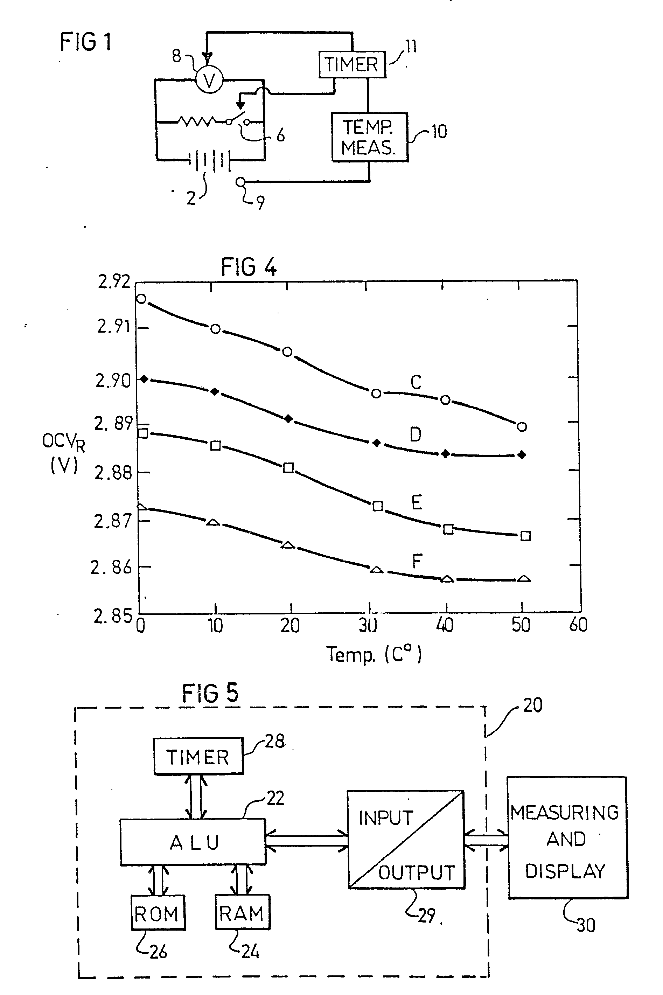

With reference to Fig. 1, there is illustrated the essential elements for determining the state-of-charge of a battery, therein designated 2, in accordance with the present invention. These elements include a high-power resistor 4 connectable across the battery 2 by means of a switch 6; a voltage-measuring circuit 8 to measure the battery voltage thereof; a temperature sensor 9 adapted to sense the temperature of the battery 2; a temperature-measuring circuit 10, and a timer circuit 11. In practicing the method by the set of the set-up schematically illustrated in Fig. 1, the temperature of battery 2 under test is first measured by temperature sensor 9 and measuring circuit 10, the measurement being effected while switch 6 is open so that no load is across the battery. Switch 6 is then closed to connect resistor 4 across the battery to produce a predetermined high discharge for a predetermined short period of time; switch 6 is then opened for a predetermined short recovery time; and then the recovery open-circuit-voltage across the battery 2 under test is measured by the voltage-measuring circuit 8. The measurements of the recovery open-circuit-voltage and of the temperature thus obtained may then be used for determining the state-of-charge of the battery 2 under test, for example, by the use of relevant calibration curves.

Thus, it has been found, particularly with respect to lithium batteries, that the state-of-charge, or residual capacity, of the battery bears, for any one temperature, a predictable relationship to the recovery open-circuit-voltage measurement when such measurement has been made after the battery has been loaded to produce a predetermined high discharge for a short period of time followed by a predetermined short recovery time. As described earlier, loading the battery, which is effected by closing switch 6 to connect resistor 4 across the battery, removes the passivating layer on the lithium anode so that the measurement is substantially free of the anodic polarization, and reflects mostly the polarization of the cathode. The recovery time between loading and measuring the recovery open-circuit-voltage has been found important to give reproducible results, since it minimizes the effects of ohmic voltage drop in the solution, and anodic polarization in the recovery open-circuit-voltage, which have little correlation with the state-of-charge of the battery and therefore can affect the accuracy of the results.

Since the measurements of recovery open-circuit-voltage for a set of defined parameters (L, $t_L$, $t_R$) provide accurate and reproducible indications of the state-of-charge of the battery, reference tables or curves can be prepared for each temperature showing the state-of-charge of the battery for the measured recovery open-circuit-voltage for the respective battery. In the case of $Li/SO_2$ batteries, it has been found that this relationship of state-of-charge to recovery open-circuit-voltage is substantially accurate and reproducible for each temperature within the range of about -40° to +70° C; therefore, reference of calibration curves can be prepared for each temperature within this range for each set of parameters (L, $t_L$, $t_R$,), each set of such parameters resulting in a different calibration curve.

Preferably, resistor 4 (Fig. 1) should be of a value so as to load the battery upon closure of switch 6 such as would produce a discharge of the full nominal capacity of the battery in 1-10 hours. In the case of 10 Ah D-size $Li/SO_2$ batteries, particularly good results have been obtained when resistor 4 has a value of 0.5 ohms multiplied by a number of cells within the battery 2 under test. Thus, if battery 2 is a single-cell battery, resistor 4 preferably has a valve of 0.5 ohms; and if the battery is a 5-cell one. resistor 4 preferably has a value of 2.5 ohms. This loading of the battery produces a discharge of the full nominal battery capacity in about two hours.

In this example, switch 6 is closed for a period of 60 seconds to produce the high discharge, following which it is opened; then after the elapse of another period of 30 seconds, the recovery open-circuit-voltage is read from the voltmeter 8. As indicated earlier, however, the loading period may generally be from about 0.1-300 seconds, a period of 10-60 seconds being preferred; and the recovery period may be from 0.1-1000 seconds, a recovery period of 10-60 seconds, also being preferred.

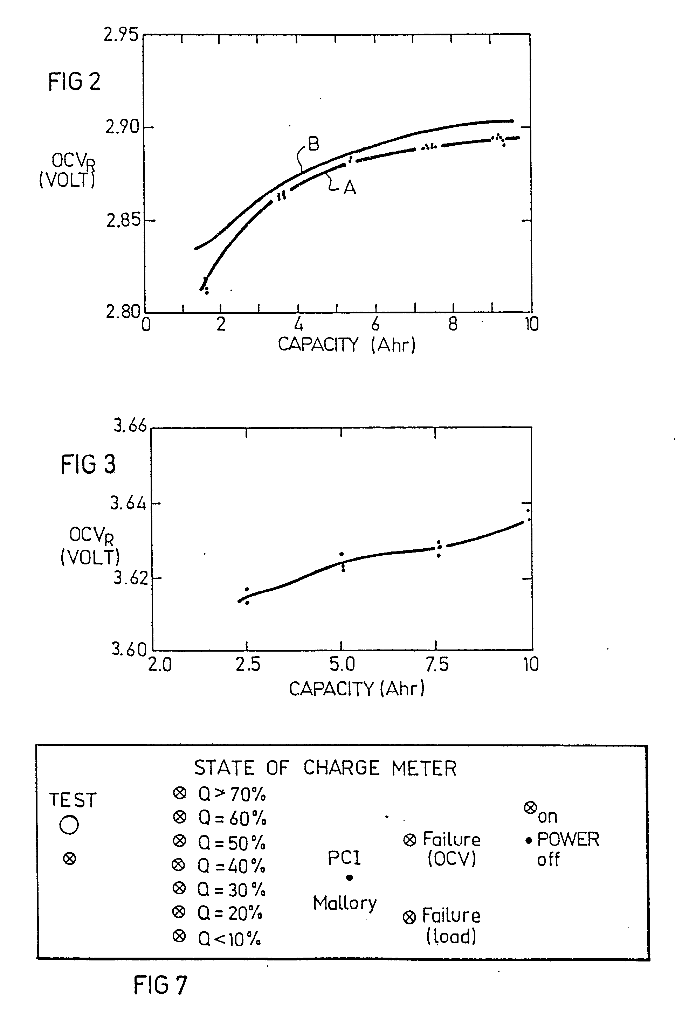

Fig. 2 illustrates the residual capacity of an $Li/SO_2$ (10 Ah D-size) battery with respect to the recovery open-circuit-voltage ($OCV_R$) measurement taken after loading the battery to produce a high discharge for a short period of time, and a short recovery period thereafter, in accordance with the procedure described above. Curve A represents this relationship with respect to a single-cell battery, wherein the loading resistor 4 in Fig. 1 had a value of 0.5 ohms; and a curve B represents the relationship with respect to a 15-volt five-cell battery, wherein resistor 4 had a value of 2.5 ohms (i.e., 0.5 5, the recovery open-circuit-voltage being the measured voltage divided by "5"). In both cases, the load was applied for a period ($t_L$) of 60 seconds, following which there was a recovery period ($t_R$) of 30 seconds; and the measurement of the curves A and B were taken at a temperature of 25° C. It will be seen that both curves have substantially the same shape, the small difference resulting from the face that the loading current of the battery was not exactly the same for the five-cell battery (curve B) as for the single-cell battery (curve A) because of a difference in the total resistance of the circuit. Both curves A and B represent the mean of a number of experiments performed with both single-cell batteries and five-cell batteries.

During these experiments, measurements were taken at temperatures of minus 40° C to 70° C, and it was found that the resulting curves were similar but varying with temperature.

Fig. 3 illustrates the results of experiments conducted with respect to $Li/SOCL_2$ batteries, the curves therein illustrated being for a single-cell D-size battery at 25° C. In this case, the loading resistor was 100 ohms, the loading period was 60 seconds, and the recovery period was 120 seconds.

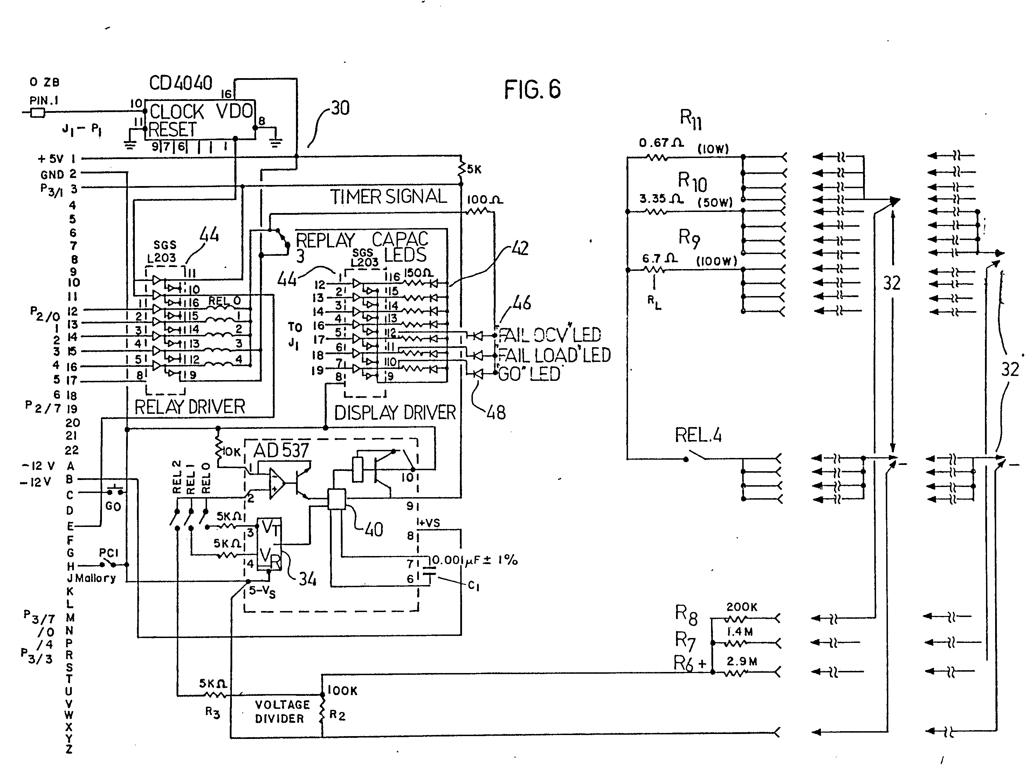

Fig. 4 illustrates the relationship of recovery open-circuit-voltage at various room temperatures for different residual capacities of 9 Ah $Li/SO_2$ batteries, namely residual capacity of: 9.4 Ah (curve C), representing a fully-charged battery; 7.1 Ah (curve D); 4.8 Ah (curve E), and 3.0 Ah (curve F). In all these tests, the loading period was 60 seconds, the recovery period was 30 seconds, and loading resistor was 0.5 ohm.

It will thus be seen that tables or curves can be prepared for each type of battery, for each temperature within the range of minus 40° C to plus 70° C, and for each set of parameters $Lt_L$, $t_R$, which curves can be used as a reference to determine the residual capacity of the respective type of battery when its recovery open-circuit-voltage and temperature are measured in accordance with the above-described procedure. Such tables or curves may be stored as look-up tables in apparatus for determining the state-of-charge or residual capacity of the battery by performing the above-described operations and then comparing the measured recovery open-circuit-voltage and temperature with the stored look-up tables.

It has been found, however, that particularly for $Li/SO_2$ batteries, the residual capacity of the battery can also be closely approximated by solving an equation, as set forth below, based on the recovery open-circuit-voltage and temperature measurements produced by following the procedure of the present invention. Thus, it was found that, in the case of $Li/SO_2$ batteries, the residual capacity (Q) of a 9 Ah battery closely approximates the following equation at 25° C with respect to the recovery open-circuit-voltage ($OCV_R$) as measured in accordance with the above-described procedure ($R_L$ = 0.5 ohm, $t_L$ = 60 sec, $t_R$ = 50 sec):

$$1nQ = OCV_R \bullet 28.05 - 79.325 \qquad Eq(1)$$

It was also found that for the temperature range of 0-50° C, the $OCV_R$-temperature relationship closely follows the following equation:

$$OCV_R = OCV_R (25) - (t - 25) 0.4 \bullet 10^{-3} \qquad Eq(2)$$

It will therefore be seen that:

$$1nQ = 28.05 [OCV_R + (T - 25) \bullet 0.4 \bullet 10^{-3}] - 79.325 \qquad Eq(3)$$

It will therefore be seen that, particularly when the method is implemented by computer apparatus, a close approximation of the residual capacity can be computed by solving the above Equation (3) from the recovery open-circuit voltage and temperature measurements obtained in accordance with the above-described procedure.

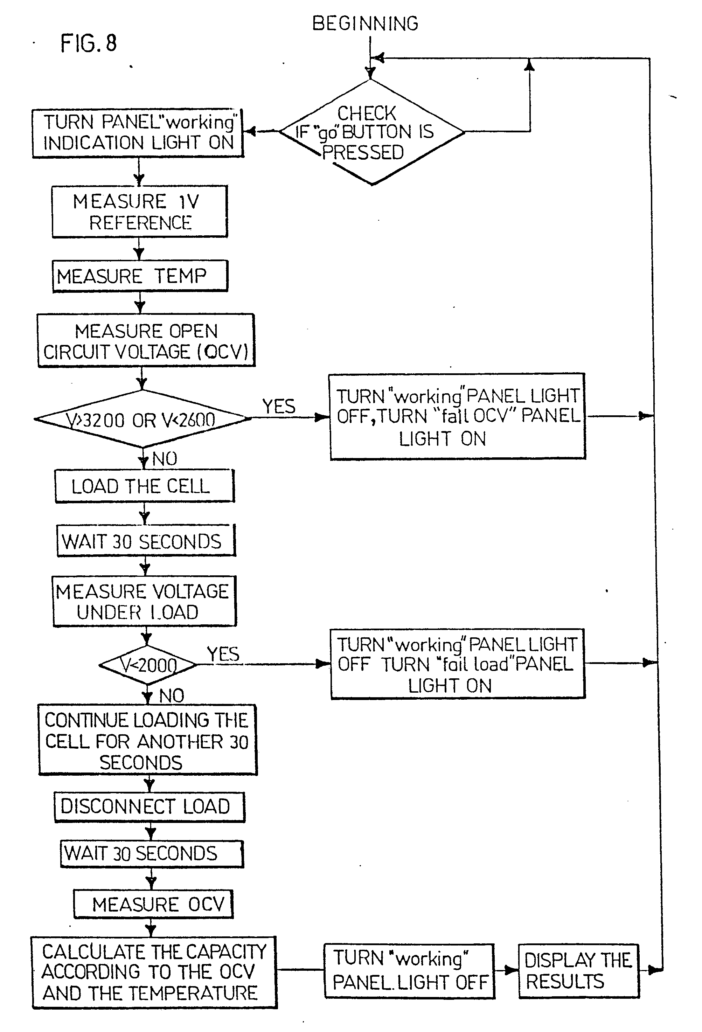

Figs. 1, 5, 6 illustrate one form of microcomputer apparatus which may be used for practicing the invention in accordance with the above-described method. Figs. 1 and 5 schematically illustrate in block diagram form the overall apparatus; Fig. 6 illustrates a specific interface for measuring and display circuit that may be used; and Fig. 8 is a flow diagram illustrating one sequence of operation for which the microprocessor in Fig. 5 may be programmed to perform.

Thus, the apparatus illustrated in Figs. 5-8 comprises a microcomputer, generally designated 20, including an ALU (Arithmetic Logic Unit) 22, a RAM (Random Access Memory) storage device 24, a ROM (Read Only Memory) storage device 26, and a timer 28. The ALU 22 communicates via input/output circuitry 29 with a measuring and display circuit 30. The latter circuit includes connectors 32 (Fig. 6) adapted to be connected to the terminals of the battery B under test, and a temperature sensor 34 for sensing the ambient (and battery) temperature.

As one example, the microcomputer 20 may be or include a Zilog Z-8 microcomputer, whose ports are connected to the measuring and display circuit 30 as shown in Figs. 5 and 6.

With reference to Fig. 6, the measuring and display circuit 30 includes a voltage-to-frequency converter, generally designated 40, which produces an output frequency proportional to the voltage at its input terminals. The voltage-to-frequency converter, in conjunction with the timer-counter inside the controller (28 Fig. 5), functions as an analogue-to-digital converter to measure voltage. The basic frequency of circuit 40 is set by a fixed external capacitor $C_1$. As one example, circuit 40 may be voltage-to-frequency converter AD537. The latter converter also produces two output voltages, one voltage being a constant reference voltage and the other being a voltage in millivolts proportional to the absolute temperature. Thus, the converter (34 Fig. 6) also contains the temperature sensor (9 Fig. 1).

The measuring and display circuit 30 further includes a display comprising 7 LED's (Light Emitting Diodes) 42 driven by drivers 44 for displaying the determined residual capacity of the battery under test. The display panel further includes two additional LED's 46 to indicate "failure," in case the measured voltage of the battery under test is too low.

The measuring and display circuit 30 further includes five relays designated REL 0-4, driven by relay drivers 43 controlled by the microcomputer 20. The contacts of the five relays are connected, as shown in Fig. 6, to perform the following functions:

Relay REL-0 connects the voltage generated by the temperature sensor 34 (which voltage is proportional to the sensed temperature) to the measuring input of the voltage-to-frequency converter 40.

Relay REL-1 connects the reference voltage (e.g., one volt) to the measuring input of the voltage-to-frequency converter 40; relay REL-2 connects the voltage of the battery under test to the measuring input of the voltage-to-frequency converter 40, the latter voltage being fed from the connector terminal 32 via a voltage-divider circuit including resistors $R_2$ and one of the resistors $R_6$, $R_7$, $R_8$.

Relay REL-3 selectively powers either the remaining relays and the two "failure" indicator LED's 46, or the seven LED's 42 displaying the measured residual capacity of the battery under test.

Relay REL-4 connects and disconnects the load resistor $R_L$ across the battery under test, which elements correspond to resistor 4 and switch 6 in the diagram of Fig. 1.

Fig. 6 illustrates the connections of the various relays to the microcomputer 20, it being appreciated that each relay is enabled by a pit outputted by the microcomputer. Briefly, when relay REL-1 is energized, the reference voltage is connected to the voltage-to-frequency converter, and the reference frequency is measured. Since the reference voltage is known (e.g., one volt), the conversion factor of the voltage-to-frequency conversion is calculated by the microcomputer. When relay REL-0 is energized, the temperature is measured by measuring the frequency. Relay REL-0 is de-energized by lowering its bits. Relay REL-2 is energized to measure the voltage of the battery under test. In order to load the battery under test to produce the high discharge for a short period of time, relay REL-4 is energized, thereby connecting the load resistor $R_L$ (one of resistors $R_9$, $R_{10}$, $R_{11}$ respectively) across the battery. The "failure" LED's are energized whenever the measured voltage across the battery is out of the correct range.

Fig. 7 illustrates, for purposes of example, the front panel of a state-of-charge meter which could be used with the above-described apparatus, which meter includes indicator lamps for indicating the various states-of-charge as well as other pertinent information.

Fig. 8 is a flow-diagram illustrating the sequence of operations which the microcomputer 20 is programmed to perform.

Thus, the test is started by depressing the "go" button, whereupon an "ON"-indicator light 48 is energized, and then the reference voltage is measured so as to determine the conversion factor of the voltage- to-frequency converter 40; as indicated earlier, this is preferably one volt. The battery temperature, as sensed by temperature sensor 34, is then measured. Next, the open-circuit-voltage of the battery under test is measured and if it is found too high or too low, this is indicated by the "OCV failure" LED's 46 on the display panel, and further testing is terminated.

Next, the battery under test if loaded by connecting load resistor $R_L$ (by energizing relay REL-4) to produce a high discharge for a predetermined short period of time, preferably for 60 seconds; this time period is determined by timer 28 (Fig. 5) of the microcomputer 20. After loading for 30 seconds, the voltage across the battery under test is again measured, and if it is found too low, the measurement is again terminated, and "load failure" LED 47 is energized. If the measured voltage is not too low, the loading of the battery is continued, to produce the high discharge for a total of 60 seconds (preferably), whereupon the load is disconnected (by de-energizing relay REL-4). The battery under test recovers for another 30 seconds after which time the recovery open-circuit- voltage is measured. The measured recovery open- circuit-voltage and the previously-measured temperature, are then used to determine the residual capacity of the battery under test. As described earlier, this may be done by comparing these measurements with the reference values stored in look-up tables (e.g., in the microcomputer ROM 26) for the various temperatures with respect to the particular battery under test; alternatively, a close approximation of residual capacity can be computed by the computer 20, by solving Equation (3) above, for D-size $Li/SO_2$ batteries.

The residual capacity computed according to either of the above techniques is then displayed by LED's 42, while the "on" light is turned off, whereupon the system returns to the beginning of the above-described sequence of operations preparatory for the next test.

While the invention has been described with respect to one preferred embodiment, it will be appreciated that many other variations, modifications, and applications of the invention may be made.

## Claims

1. The method of determining the state-of-charge of a battery, particularly one having an unknown history, comprising the steps:

(a) loading the battery with a predetermined load to produce a high discharge for a short predetermined time;

(b) after a short recovery time, measuring the recovery open-circuit-voltage and the corresponding recovery time of the battery; and

(c) determining the state-of-charge of the battery from the measured recovery open-circuit-voltage for the predetermined load, loading time, and recovery time for the particular type battery.

2. The method according to Claim 1, wherein the temperature of the battery is also measured and is also used in determining the state-of-charge of the battery.

3. The method according to either of Claims 1 or 2, wherein step (b) is effected by measuring the recovery open-circuit-voltage after a predetermined recovery time.

4. The method according to either of Claims 1 or 2, wherein step (b) is effected by measuring the recovery time to reach a predetermined recovery open-circuit-voltage.

5. The method according to any one of Claims 1-4, wherein said predetermined load in step (b) is such as would produce a discharge of full nominal capacity in 1-30 hours.

6. The method according to any one of Claims 1-5, wherein said predetermined loading time in step (b) is 0.1-300 seconds.

7. The method according to any one of Claims 1-6, wherein said recovery time before measuring the open-circuit-voltage in step (c) is 0.1-1000 seconds.

8. The method according to any one of Claims 1-7, wherein the state-of-charge of the battery is determined by comparing the measured temperature and recovery open-circuit-voltage with reference tables showing the state-of-charge at different temperatures and recovery open-circuit-voltages for the respective battery, load, loading time and recovery time.

9. The method according to any one of Claims 1-8, wherein the battery is an $Li/SO_2$, $Li/SOCl_2$, or a zinc-manganese-dioxide alkaline battery.

10. The method according to any one of Claims 1-8, wherein the battery is a 10 $AhLi/SO_2$ battery, the load is 0.5 ohm, the loading period is 60 seconds, the recovery time is 30 seconds, and the state-of-charge of the battery is determined by computing it from the measured temperature and recovery open-circuit-voltage according to the following equation:

$1nQ = 28.05 [OCV_R + (T - 25) \bullet 0.4 \bullet 10^{-3}] - 79.325$ wherein:

Q is the residual charge in amp hours;

$1nQ$ is the natural log of Q;

$OCV_R$ is the measured recovery open-circuit-voltage divided by the number of cells in series, at temperature T;

T is the measured temperature.

FIG 1

FIG 4

FIG 5

FIG 2

OCV$_R$
(VOLT)

2.95

2.90

2.85

2.80

B

A

0    2    4    6    8    10
CAPACITY (Ahr)

FIG 3

OCV$_R$
(VOLT)

3.66

3.64

3.62

3.60

2.0    2.5    5.0    7.5    10
CAPACITY (Ahr)

STATE OF CHARGE METER

TEST
○

⊗

⊗ Q > 70%
⊗ Q = 60%
⊗ Q = 50%
⊗ Q = 40%
⊗ Q = 30%
⊗ Q = 20%
⊗ Q < 10%

PCI
●
Mallory

⊗ Failure
(OCV)

⊗ Failure
(load)

⊗on
● POWER
off

FIG 7

FIG. 6

FIG. 8

BEGINNING

CHECK IF "go" BUTTON IS PRESSED

TURN PANEL "working" INDICATION LIGHT ON

MEASURE 1V REFERENCE

MEASURE TEMP

MEASURE OPEN CIRCUIT VOLTAGE (OCV)

V>3200 OR V<2600 — YES → TURN "working" PANEL LIGHT OFF, TURN "fail OCV" PANEL LIGHT ON

NO

LOAD THE CELL

WAIT 30 SECONDS

MEASURE VOLTAGE UNDER LOAD

V<2000 — YES → TURN "working" PANEL LIGHT OFF TURN "fail load" PANEL LIGHT ON

NO

CONTINUE LOADING THE CELL FOR ANOTHER 30 SECONDS

DISCONNECT LOAD

WAIT 30 SECONDS

MEASURE OCV

CALCULATE THE CAPACITY ACCORDING TO THE OCV AND THE TEMPERATURE

TURN "working" PANEL LIGHT OFF

DISPLAY THE RESULTS

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | PATENT ABSTRACTS OF JAPAN, vol. 7, no. 168 (P-212)[1313], 23rd July 1983; & JP-A-58 76 778 (FURUKAWA DENCHI K.K.) 09-05-1983 * Abstract * | 1-3,8 | G 01 R 31/36 |
| Y | IDEM --- | 4 | |
| Y | US-A-4 321 541 (SHIBAURA) * Abstract * --- | 4 | |
| A | EP-A-0 071 439 (CURTIS) * Abstract * --- | 1-3 | |
| A | US-A-4 322 685 (GLOBE-UNION) ----- | | |

TECHNICAL FIELDS SEARCHED (Int. Cl.4)

G 01 R

The present search report has been drawn up for all claims

| Place of search | Date of completion of the search | Examiner |
|---|---|---|
| THE HAGUE | 09-09-1988 | HOORNAERT W. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)